# FASCICULE DE BREVET EUROPEEN

(11) **EP 2 833 555 B1**
(45) Date de publication et mention de la délivrance du brevet: **24.07.2019**
(21) Numéro de dépôt: 14178275.5
(22) Date de dépôt: 24.07.2014
(51) Int. Cl.: H03M 13/11, H03M 13/29

(54) **Procede ameliore de decodage d'un code correcteur avec passage de message, en particulier pour le decodage de codes ldpc ou codes turbo**
Verbessertes Verfahren zur Decodierung eines Korrekturcodes mit Message Passing, insbesondere für die Decodierung von Low-Density-Parity-Check-Codes oder Turbo-Codes
Improved method for decoding a corrector code with message passing, in particular for the decoding of LDPC codes or turbo codes

(30) Priorité: 02.08.2013 FR 1301859
(43) Date de publication de la demande: 04.02.2015
(73) Titulaire: Thales, 92400 Courbevoie (FR)
(72) Inventeur: Gadat, Benjamin, 31037 TOULOUSE Cedex 1 (FR); Van Wambeke, Nicolas, 31037 TOULOUSE Cedex 1 (FR)
(74) Mandataire: Hammes, Pierre

(56) Documents cités:
- EP-A1- 2 501 049
- EP-A2- 1 959 572
- WO-A1-2014/187495
- US-A1- 2010 088 575
- US-A1- 2012 005 551
- Sudan, M.: "List Decoding: algorithms and applications", MIT Information Theory Online Repository , 9 mai 2000 (2000-05-09), pages 1-19, XP002722457, Extrait de l'Internet: URL:http://theory.lcs.mit.edu/%7Emadhu/pap ers/noneed/ifip-journ.ps [extrait le 2014-03-28]
- ERAN SHARON ET AL: "Efficient Serial Message-Passing Schedules for LDPC Decoding", IEEE TRANSACTIONS ON INFORMATION THEORY, IEEE PRESS, USA, vol. 51, no. 11, 1 novembre 2007 (2007-11-01), pages 4076-4091, XP011196253, ISSN: 0018-9448
- NEDELJKO VARNICA ET AL: "Augmented Belief Propagation Decoding of Low-Density Parity Check Codes", IEEE TRANSACTIONS ON COMMUNICATIONS, IEEE SERVICE CENTER, PISCATAWAY, NJ. USA, vol. 55, no. 7, 1 juillet 2007 (2007-07-01), pages 1308-1317, XP011187493, ISSN: 0090-6778, DOI: 10.1109/TCOMM.2007.900611

## Description

La présente invention concerne le domaine des télécommunications numériques et plus précisément le domaine du codage de canal qui vise l'utilisation de codes correcteurs dans le but d'augmenter le niveau de redondance de l'information transmise de sorte à pouvoir reconstruire le message initialement généré malgré les erreurs introduites lors de la transmission de ce message à travers un canal de propagation non parfait.

L'invention porte en particulier sur un procédé de décodage amélioré d'un code correcteur applicable aux algorithmes de décodage avec passage de message ou, selon la terminologie anglo-saxonne, « message passing ». L'invention s'applique avantageusement aux codes LDPC (« Low Density Parity Check ») et aux turbo-codes mais également à tout autre code correcteur qui peut être représenté via une matrice de parité et qui peut être décodé itérativement au moyen d'un algorithme avec passage de message au cours duquel des informations extrinsèques sont générées, pour chaque bit à décoder, dans le but d'améliorer la fiabilité des décisions au cours des itérations.

Les familles de codes correcteurs qui peuvent être décodés de manière itérative sont des familles particulières de codage canal qui comprennent notamment les codes LDPC et les codes turbo. Par la suite on utilise l'expression « codes de la famille turbo » pour désigner tous les codes correcteurs qui peuvent être représentés par une matrice de parité et qui peuvent être décodés de manière itérative au moyen d'un algorithme avec passage de message.

Ces codes permettent d'obtenir de bonnes performances en taux d'erreur paquet ou bit fonction du rapport signal à bruit, néanmoins ils présentent deux inconvénients majeurs.

En premier lieu, les performances de ces codes présentent une limite plancher au-delà de laquelle le taux d'erreur ne diminue plus malgré une augmentation du rapport signal à bruit en réception. Ce phénomène est connu du domaine sous le nom « error floor » ou plancher d'erreurs en français.

En second lieu, les performances de ces codes sont sensiblement dégradées pour des tailles de paquets réduites (typiquement de 100 à 500 bits). En effet, même si ces familles de codes sont connues pour permettre d'approcher asymptotiquement la capacité théorique du canal au sens du théorème de Shannon, l'écart par rapport à la capacité réellement atteinte, pour des tailles de paquets réduites, est souvent important.

Une première solution connue pour améliorer les performances des codes de la famille turbo consiste à lui adjoindre un code externe, de type code BCH ou code de Reed-Solomon, pour former un schéma de codage concaténé. Cette méthode, bien qu'efficace en terme de performances, présente l'inconvénient de diminuer le débit utile de la transmission.

Une deuxième solution connue, décrite dans la référence [2] consiste à analyser le spectre des mots de code afin d'identifier les bits les moins protégés dans la trame produite en entrée de décodage. En effet, pour de tels codes, tous les bits ne sont pas protégés de manière équitable et l'impact d'une erreur sur un bit donné n'est donc pas le même que celui d'une erreur sur un autre bit. Une fois l'ensemble *Ω* de ces bits déterminé, un turbo codeur insère, aux positions signifiées par l'ensemble *Ω*, des bits connus. En conséquence, lors du décodage, l'ensemble *Ω* ainsi que les valeurs des bits insérés étant connus, une fiabilité importante est déclarée à l'entrée du turbo-décodeur afin d'en améliorer les performances. Les bits insérés sont ensuite retirés à la sortie du turbo-décodeur afin de retrouver la trame d'information initiale.

Là encore, cette technique possède le défaut de diminuer le rendement effectif du code puisque des bits d'information sont supprimés et remplacés par des bits de valeurs connues.

Une troisième solution, proposée dans [3] consiste à introduire des impulsions à certaines positions de la trame d'entrée du décodeur. Ces positions sont déterminées en se basant sur les informations de vraisemblance des bits en entrée du décodeur. Les vraisemblances sont triées en fonction de leur magnitude uniquement et les impulsions sont introduites une a une dans la trame en commençant par les vraisemblances les moins fiables.

Cette méthode est efficace, mais a pour principal défaut d'être très complexe à mettre en oeuvre. En effet, elle apparaît efficace pour un grand nombre de positions et repose sur le principe que tous les bits dans la trame ont la même importance, ce qui n'est pas le cas pour un code de la famille turbo.

Une quatrième solution, décrite dans la référence [4], consiste à modifier les règles de décision du décodeur afin de tirer parti de la diversité du décodeur.

Cette méthode ne fonctionne que pour des codes LDPC et pas pour d'autres codes de la même famille. De plus elle nécessite une paramétrisation complexe du décodeur.

Enfin, on connait également la solution décrite dans [5] qui consiste à tenter d'identifier un certain nombre de noeuds erronés dans le graphe du décodeur afin d'effectuer plusieurs passes de décodage. Cependant, cette méthode présente une complexité élevée car l'algorithme proposé nécessite de conserver l'ensemble des messages échangés par le décodeur au cours des différents essais de décodage. En outre, la méthode décrite dans [5] n'est compatible que d'un type particulier d'algorithme de décodage et ne fonctionne qu'avec des valeurs souples en entrée.

Afin de remédier aux limitations précitées des solutions connues, la présente invention propose un procédé itératif de décodage qui permet d'approcher les performances du décodage à maximum de vraisemblance.

Le procédé selon l'invention est basé sur l'identification, en entrée du décodeur, des bits les moins fiables à partir des changements de signe des informations extrinsèques échangées au cours du décodage itératif, l'algorithme de décodage employé étant du type « message passing », c'est-à-dire que, pour chaque bit à décoder, une information extrinsèque est générée à chaque itération de décodage en vue d'améliorer la fiabilité de la décision de décodage.

L'invention a ainsi pour objet un procédé de décodage itératif d'un mot d'un code correcteur au moyen d'un algorithme itératif de décodage au cours duquel, pour chaque bit dudit mot de code, au moins une information extrinsèque est générée à chaque itération, tel que définit par les revendications.

L'invention a également pour objet un système récepteur de communications comprenant des moyens adaptés pour exécuter les étapes du procédé de décodage itératif selon l'invention, un programme d'ordinateur comportant des instructions pour l'exécution du procédé de décodage itératif selon l'invention, lorsque le programme est exécuté par un processeur et un support d'enregistrement lisible par un processeur sur lequel est enregistré un programme comportant des instructions pour l'exécution du procédé de décodage itératif selon l'invention, lorsque le programme est exécuté par un processeur.

D'autres caractéristiques et avantages de la présente invention apparaîtront mieux à la lecture de la description qui suit en relation aux dessins annexés qui représentent:
- La figure 1, un organigramme décrivant les étapes de mise en oeuvre du procédé selon l'invention,
- La figure 2, un schéma illustrant la représentation d'un code correcteur du type LDPC au moyen d'un graphe de Tanner,
- Les figures 3a et 3b, deux schémas illustrant, dans une étape particulière du procédé, l'emploi d'une arborescence et son parcours selon deux modes de réalisation de l'invention différents,
- La figure 4, un schéma illustrant les échanges d'information extrinsèques lors du décodage d'un turbo-code

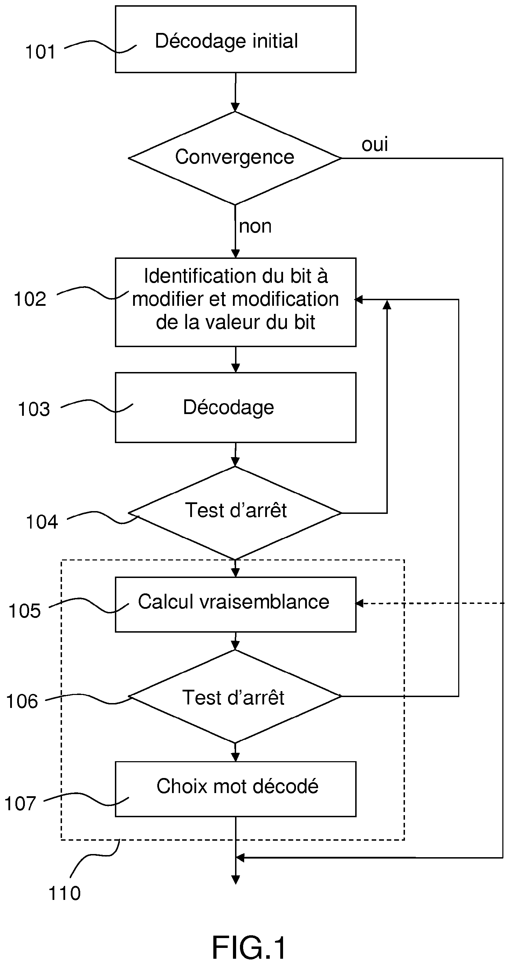

La figure 1 décrit, sur un organigramme, l'enchainement des étapes de mise en oeuvre du procédé selon l'invention pour le décodage d'un mot de code d'un code correcteur donné.

En premier lieu, on décrit un premier mode de réalisation de l'invention adapté au décodage des codes LDPC.

Dans une étape préliminaire 101, une première instance de décodage est exécutée pour décoder le mot de code. Selon un premier mode de réalisation de l'invention, l'algorithme de décodage utilisé est basé sur l'emploi d'un graphe bipartite, appelé graphe de Tanner. Un tel graphe est notamment adapté pour le décodage de codes LDPC.

L'ouvrage de référence [1], et en particulier le chapitre 5 intitulé « Low-density parity-check codes », décrivent en détail l'emploi d'un graphe de Tanner pour le décodage d'un code LDPC et différents algorithmes de décodage basés sur un tel graphe (en particulier l'algorithme somme-produit). L'algorithme de décodage utilisé dans l'étape préliminaire 101 du procédé selon l'invention peut être l'un de ceux décrits au chapitre 5 dudit ouvrage ou tout autre algorithme équivalent à condition qu'il soit basé sur un graphe bipartite de Tanner. Un tel algorithme n'est pas décrit en détail dans le présent document car l'Homme du métier, spécialiste des codes correcteurs, saura se référer à l'ouvrage [1] ou tout autre ouvrage de référence du domaine pour implémenter cet algorithme.

Un graphe de Tanner est un graphe bipartite composé de deux types de noeuds. Un premier type de noeud est appelé noeud variable ou, en anglais « variable node » ou encore « code-bit node » selon les usages. Les noeuds variables sont chacun associés à un bit du mot de code produit en entrée de l'algorithme de décodage. Il y a donc autant de noeuds variables que de bits dans le mot de code à décoder. Chaque noeud variable est connecté à un ou plusieurs noeuds de contrôle, appelés « check nodes » ou « constraint nodes » en anglais. Le nombre de noeuds de contrôle est égal au nombre de lignes de la matrice de parité du code correcteur. Un noeud de contrôle d'indice i est connecté à un noeud variable d'indice j si et seulement si l'élément de la ligne i et de la colonne j de la matrice de parité du code est égal à 1.

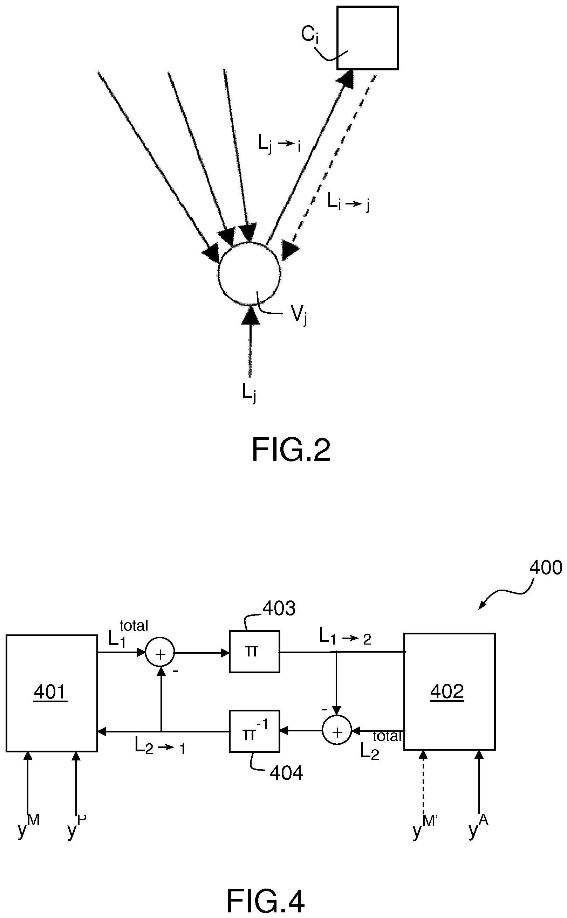

La figure 2 représente une portion d'un graphe de Tanner comprenant un noeud variable Vⱼ et un noeud de contrôle Cᵢ reliés entre eux. Sur l'exemple de la figure 2, le noeud variable Vⱼ est également connecté à trois autres noeuds de contrôle. Le noeud variable Vⱼ est initialisé avec la valeur Lⱼ du bit d'indice j du mot de code reçu en entrée de l'algorithme. Cette valeur peut être binaire mais est le plus souvent une valeur dite souple égale au logarithme du rapport de vraisemblance LLR. A chaque itération de l'algorithme de décodage, le noeud variable Vⱼ transmet une information extrinsèque L_{j->i} vers les noeuds de contrôle auxquels il est connecté et reçoit une information extrinsèque L_{i->j} des noeuds de contrôle auxquels il est connecté.

La notion d'information extrinsèque est bien connue du domaine et est par exemple explicitée dans l'ouvrage de référence [1], chapitre 5. Elle peut être égale à une information du type logarithme de rapport de vraisemblance. Le rapport de vraisemblance étant défini par le ratio entre la probabilité d'avoir un bit à 0 sachant le mot de code reçu et la probabilité d'avoir un bit à 1 sachant le mot de code reçu.

Simultanément au décodage et pour chaque noeud variable associé à chaque bit du mot de code à décoder, le nombre de changements de signe de l'information extrinsèque reçue par le noeud variable est comptabilisé et sauvegardé jusqu'à l'issu du décodage.

Le nombre de changements de signe peut être compté sur l'ensemble des informations extrinsèques reçues par le noeud variable, en provenance de tous les noeuds de contrôle auquel il est connecté ou en calculant au préalable une information extrinsèque globale égale à la somme des informations extrinsèques reçues puis en comptant le nombre de changements de signe de l'information extrinsèque globale.

A l'issu du décodage, on a donc, pour chaque bit décodé, une information associée sur le nombre de changements de signe de l'information extrinsèque reçue par le noeud variable associé à ce bit.

Cette information donne une indication sur la fiabilité du bit décodé et est utilisée, par la suite, pour améliorer le décodage en effectuant une ou plusieurs passes successives de décodage.

Si le décodage effectué lors de l'étape préliminaire 101 converge, alors le mot décodé obtenu est retenu et le processus est arrêté. Dans une variante de réalisation, le mot décodé est ajouté à une liste de plusieurs mots décodés parmi lesquels sera choisi le mot le plus vraisemblable selon un critère décrit plus en détail par la suite.

Le critère de convergence utilisé peut être n'importe quel critère usuel, en particulier ce critère peut consister en une vérification d'un code CRC adjoint au mot de code reçu ou en une détection de syndrome ou tout autre critère permettant de définir une convergence de l'algorithme de décodage.

Si le décodage effectué lors de l'étape préliminaire 101 ne converge pas, alors, dans une nouvelle étape 102 du procédé selon l'invention, on identifie, dans le mot de code produit en entrée de l'algorithme de décodage, le bit qui correspond au noeud variable du graphe de Tanner pour lequel le nombre de changements de signe de l'information extrinsèque reçue est le plus élevé. La valeur du bit identifié est ensuite modifiée afin de produire un mot de code modifié.

La modification opérée sur le bit identifié est différente selon que le mot de code produit en entrée du procédé est binaire ou est constitué de valeurs souples. Dans le premier cas, la valeur du bit est modifiée en inversant le bit identifié, c'est-à-dire en modifiant sa valeur de 0 vers 1 ou de 1 vers 0. Dans le second cas, la valeur du bit est saturée aux valeurs maximales et minimales possibles selon la plage de variation des valeurs souples. Par exemple, si une valeur souple est quantifiée pour varier entre les bornes -S et + S, où S est un nombre positif, alors, la modification du bit identifié consiste à saturer la valeur de ce bit respectivement à la valeur +S et à la valeur -S de sorte à produire deux mots de code modifiés.

Cette modification permet d'aider le décodeur en effectuant une décision préalable sur le bit identifié comme peu fiable du fait des nombreux changements de signe de l'information extrinsèque associée qui traduisent une instabilité dans la prise de décision du décodeur.

Dans une étape suivante 103, le processus de décodage est réitéré, en utilisant le même algorithme de décodage que lors de l'étape préliminaire 101 mais en l'appliquant au mot de code modifié. Dans le cas où deux mots de code modifiés sont produits, l'étape 103 consiste à exécuter l'algorithme de décodage sur ces deux mots alternativement.

Les étapes 102 et 103 sont itérées plusieurs fois jusqu'à vérifier un test d'arrêt 104.

On décrit à présent plusieurs variantes de réalisation des itérations des étapes 102,103,104.

Selon une première variante, à chaque itération, on modifie la valeur du bit du mot de code associé au noeud variable pour lequel le nombre de changements de signe de l'information extrinsèque reçue est le plus élevé parmi les bits dont la valeur n'a pas été modifiée à une itération précédente.

Autrement dit, les bits du mot de code sont triés dans l'ordre décroissant du nombre associé de changements de signe puis le décodage 103 est exécuté en modifiant, à chaque itération, la valeur du bit suivant, dans l'ordre décroissant prédéfini. A chaque nouvelle itération, le mot de code est réinitialisé avant de modifier la valeur d'un seul de ses bits.

Cette variante présente l'avantage d'être peu complexe car elle ne nécessite qu'un seul comptage de changements de signe au sein de la passe initiale de décodage.

Selon une deuxième variante, à chaque itération de décodage 103, un nouveau comptage du nombre de changements de signe de l'information extrinsèque reçue par chaque noeud variable, au cours du décodage 103, est effectué et on modifie, dans le mot de code modifié à l'itération précédente, la valeur du bit associé au noeud variable pour lequel le nombre de changements de signe est le plus élevé.

Cette deuxième variante présente l'avantage d'une amélioration des performances de décodage car les aides à la décision, sous forme de modification des bits du mot de code, sont affinées par itération successives.

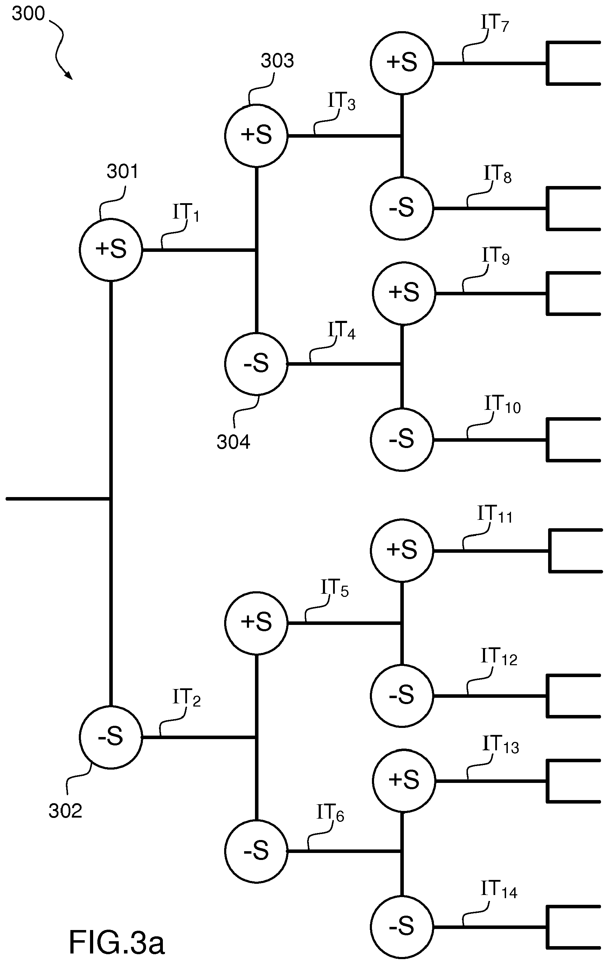

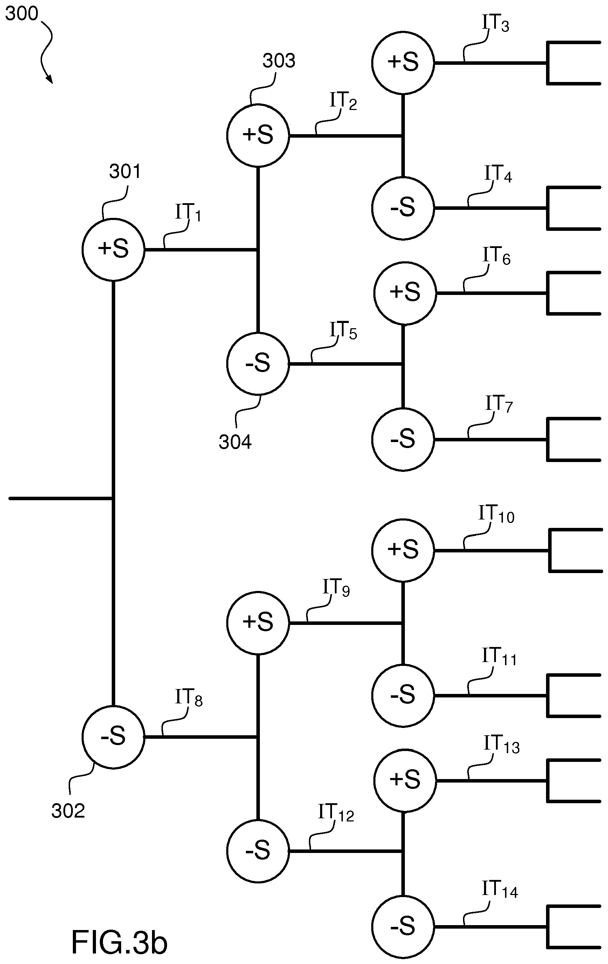

Selon cette deuxième variante et dans le cas où le mot de code comporte des valeurs souples, les itérations de décodage 103 peuvent être représentées sous la forme d'une arborescence telle qu'illustrée aux figures 3a et 3b.

Dans une telle arborescence 300, les noeuds 301,302,303,304 de l'arbre correspondent chacun à une itération de décodage associée à l'une des deux valeurs de saturation -S,+S du bit modifié.

L'arborescence 300 peut être parcourue en largeur d'abord, comme illustré sur la figure 3a. Dans ce cas, la première itération IT1 de décodage est appliquée au mot de code initial modifié avec la valeur de saturation positive +S, puis la deuxième itération IT2 de décodage est appliquée au mot de code initial modifié avec la valeur de saturation négative -S. Ensuite, le deuxième niveau de profondeur de l'arbre est parcouru. Autrement dit, la troisième itération IT3 de décodage est appliquée au mot de code modifié à la première itération modifié avec la valeur de saturation positive +S, la quatrième itération IT4 de décodage est appliquée au mot de code modifié à la première itération modifié avec la valeur de saturation négative -S, la cinquième itération IT5 de décodage est appliquée au mot de code modifié à la deuxième itération modifié avec la valeur de saturation positive +S, la sixième itération IT6 de décodage est appliquée au mot de code modifié à la deuxième itération modifié avec la valeur de saturation négative -S. Les niveaux de profondeurs suivants de l'arbre sont parcourus de la même façon. A chaque itération, on conserve le mot de code modifié à l'étape précédente et on modifie la valeur du bit associé au noeud variable pour lequel le nombre de changements de signe de l'information extrinsèque reçue est le plus élevé.

Le nombre de niveaux de profondeurs, autrement dit le nombre d'itérations maximum, est fixé à priori.

La figure 3b représente la même arborescence mais illustre un parcours de l'arbre en profondeur et non en largeur comme pour la figure 3a.

Selon la variante représentée à la figure 3b, l'arbre est parcouru en testant d'une part les noeuds fils du noeud 301 correspondant au mot de code initial modifié avec la valeur de saturation positive +S et d'autre part les noeuds fils du noeud 302 correspondant au mot de code initial modifié avec la valeur de saturation négative -S.

Cette variante présente l'avantage de pouvoir paralléliser les itérations de décodage en effectuant simultanément les itérations issues du noeud 301 et celles issues du noeud 302.

Quel que soit le mode de parcours de l'arborescence, selon une autre variante de réalisation, l'arbre peut être élagué en éliminant les noeuds fils d'un noeud correspondant à une itération qui a abouti à la convergence du décodeur. En effet, si le décodeur converge, la probabilité de trouver un autre candidat, pour le mot décodé, qui soit plus vraisemblable parmi les noeuds fils est infime. L'élagation de l'arbre permet de diminuer la complexité en supprimant des itérations de décodage inutiles.

Le test d'arrêt 104 utilisé pour arrêter les itérations de décodage 103 peut prendre plusieurs formes.

Selon une première variante, les itérations 102,103 sont arrêtées dès que le décodeur converge.

Selon une deuxième variante, les itérations 102,103 sont arrêtées au bout d'un nombre prédéterminé d'itérations, par exemple correspondant à un degré de profondeur de l'arborescence 300.

Dans une variante de réalisation de l'invention, un groupe 110 d'étapes supplémentaires sont exécutées avant de déterminer le mot décodé retenu.

Selon une première étape 105 de ce groupe 110, les mots décodés obtenus à l'issu du test d'arrêt 104 ou à l'issu de la première passe de décodage initial 101, dans le cas où le décodeur a convergé, sont stockés dans une liste de mots décodés candidats. Cette liste présente une taille prédéterminée, par exemple égale à trois candidats maximum.

Pour chaque candidat de la liste, un critère de vraisemblance du mot décodé est calculé.

Lorsque 106 le nombre de mots candidats est égal au nombre de mots maximum de la liste, on choisit 107, le candidat qui permet d'optimiser le critère de vraisemblance.

Ces étapes supplémentaires 105,106,107 permettent encore d'améliorer les performances de décodage en sélectionnant le mot décodé le plus vraisemblable parmi plusieurs candidats.

Le critère de vraisemblance utilisé dépend de la nature du mot de code en entrée du décodeur.

Si le mot de code contient des données binaires, le critère peut consister à sommer les produits deux à deux entre le bit reçu modulé (c'est-à-dire qui peut prendre les valeurs +1 ou -1)) en entrée du décodeur et le bit décidé modulé du mot décodé candidat puis à sélectionner le mot décodé candidat qui minimise ce critère.

Si le mot de code contient des données souples, le critère peut consister à sommer les produits deux à deux entre la vraisemblance du bit reçu en entrée du décodeur et le bit décidé modulé du mot décodé candidat puis à sélectionner le mot décodé candidat qui maximise ce critère.

Tout autre critère de vraisemblance équivalent, connu du domaine des algorithmes de décodage de codes correcteurs, peut être utilisé en lieu et place des deux critères précités.

Selon un deuxième mode de réalisation de l'invention, le procédé de décodage peut également s'appliquer aux turbo-codes.

Dans ce cas, l'algorithme de décodage utilisé pour exécuter les étapes 101 et 103 du procédé selon l'invention, ne se base plus sur l'emploi d'un graphe de Tanner mais sur un décodage itératif avec échanges d'informations extrinsèques entre deux décodeurs.

La figure 4 schématise le fonctionnement d'un décodeur adapté au décodage de turbo-codes.

Un tel décodeur 400 comporte notamment un premier décodeur unitaire 401 d'un premier code correcteur et un second décodeur unitaire 402 d'un second code correcteur reliés entre eux par un premier et un second entrelaceurs 403,404.

Le fonctionnement détaillé d'un tel décodeur 400 est connu du domaine et décrit notamment au chapitre 7 de l'ouvrage de référence [1]. Il ne fait pas l'objet de l'invention et n'est donc pas décrit en détail dans la présente demande de brevet.

En synthèse, le décodeur 400 fonctionne itérativement selon le principe suivant. Pour chaque bit du mot de code à décoder, le premier décodeur unitaire 401 est exécuté et permet de générer une première information extrinsèque L_{1->2} qui est transmise au second décodeur unitaire 402 qui exploite cette information pour décoder à son tour le mot de code et générer une seconde information extrinsèque L_{2->1}. Cette seconde information est retransmise au premier décodeur 401 en vue de l'exécution d'une nouvelle itération du décodeur 400. Le processus est poursuivi avec plusieurs itérations successives. A la fin de la dernière itération, une décision est prise par le second décodeur unitaire 402 pour obtenir le mot décodé.

Les informations extrinsèques échangées entre les deux décodeurs unitaires, pour chaque bit du mot de code, sont de même nature que les informations extrinsèques échangées entre les noeuds d'un graphe bipartite de Tanner.

Ainsi, pour appliquer le procédé selon l'invention au décodage d'un turbo-code, il suffit de remplacer l'information extrinsèque reçue par un noeud variable au cours du décodage d'un code LDPC, par une information extrinsèque échangée entre les deux décodeurs unitaires 401,402 au cours du décodage d'un turbo-code.

A ce sujet, plusieurs variantes de réalisation sont possibles.

Selon une première variante, seule l'information extrinsèque L_{1->2} reçue par le second décodeur 402 est prise en compte pour le comptage du nombre de changements de signe tel que décrit précédemment pour le cas des codes LDPC. Les changements de signe sont comptés lors des itérations successives de décodage.

En effet, la prise de décision relative au décodage étant in fine réalisée par le second décodeur 402, les changements de signe de l'information extrinsèque reçue par celui-ci donnent une indication sur la fiabilité du bit décodé associé. Si de nombreuses oscillations ont eu lieu lors des différentes itérations successives de décodage, cela indique une instabilité sur la décision relative à la valeur du bit décodé. Autrement dit, plus les oscillations de l'information extrinsèque sont nombreuses, plus la valeur réelle du bit est incertaine.

Selon une deuxième variante, le comptage du nombre de changements de signe peut prendre en compte à la fois l'information extrinsèque L_{1->2} reçue par le second décodeur 402 et l'information extrinsèque L_{2->1} reçue par le premier décodeur 401.

Selon une troisième variante, le comptage du nombre de changements de signe peut être remplacé par le comptage du nombre de fois où, au cours des itérations successives de décodage, les signes de l'information extrinsèque L_{1->2} reçue par le second décodeur 402 et de l'information extrinsèque L_{2->1} reçue par le premier décodeur 401 sont opposés. En effet, lorsque, pour un même bit, les signes des informations extrinsèques échangées par les deux décodeurs lors d'une demi-itération sont opposés, cela est également indicateur d'une oscillation dans la prise de décision sur la valeur du bit décodé.

De façon plus générale, le critère relatif au nombre de changements de signe d'une information extrinsèque échangée au cours des itérations de décodage ou du nombre de différences de signe entre deux informations extrinsèques peut être remplacé par tout critère équivalent qui est représentatif des oscillations d'une ou de plusieurs informations extrinsèques ou d'une information extrinsèque vis-à-vis d'une autre. Ainsi, pour appliquer le procédé selon l'invention au décodage d'un autre type de code correcteur utilisant un autre type d'algorithme à passage de message que ceux décrits dans les deux exemples précités, l'Homme du métier saura adapter le critère à utiliser au fonctionnement intrinsèque du décodeur utilisé pour élaborer un critère équivalent.

Le procédé de décodage selon l'invention peut être implémenté à partir d'éléments matériel et/ou logiciel. Il peut notamment être mis en oeuvre en tant que programme d'ordinateur comportant des instructions pour son exécution. Le programme d'ordinateur peut être enregistré sur un support d'enregistrement lisible par un processeur.

Il peut être utilisé dans un contexte de transmission d'un flux de données codées entre un émetteur et un récepteur, le procédé selon l'invention étant implémenté par le récepteur.

Il peut également être exécuté à partir d'un flux de données codées et stockées dans un dispositif de stockage.

Les différentes étapes du procédé selon l'invention peuvent également être exécutées par un dispositif comprenant un processeur et une mémoire. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gâte Array »).

### Références

[1] « Channel codes, classical and modem », William E. Ryan, Shu Lin, Cambridge university press.
[2] M. Oberg & P. Siegel, « Application of distance spectrum analysis to turbo code performance improvement », Proc. 35th Annu. Conf. Commun, Control and Computing. pp 701-710, Sept 1997.
[3] Y. Ould-Cheikh-Mouhamedou, "A Method for Lowering Turbo Code Error Flare using Correction Impulses and Repeated Decoding", 6th international ITG-Conference on Source and Channel Coding (Turbocoding), 2006 4th international symposium
[4] "Approaching Maximum Likelihood decoding of finite length LDPC codes via FAID diversity", D. Declercq et al.
[5] "Augmented Belief Propagation Decoding of Low-Density Parity Check Codes", Varnica et al. IEEE Trans on Com 2007

## Revendications

1. Procédé de décodage itératif d'un mot d'un code correcteur au moyen d'un algorithme itératif de décodage au cours duquel, pour chaque bit dudit mot de code, au moins une information extrinsèque (L_{i->j}, L_{1->2,} L_{2->1}) est générée à chaque itération, ledit procédé comportant les étapes suivantes :
- une étape initiale de décodage (101) dudit mot de code au moyen dudit algorithme itératif de décodage,
- simultanément audit décodage itératif, pour chaque bit dudit mot de code, une étape de détermination du nombre de changements de signes d'au moins une information extrinsèque (L_{i->j}, L_{i->2,} L_{2->1}) ou du nombre de différences de signes entre une information extrinsèque (L_{1->2}) et une autre information extrinsèque (L_{2->1}),au cours de l'ensemble des itérations successives dudit algorithme itératif de décodage, si le décodage ne converge pas, ledit procédé comporte aussi
- une étape de modification (102), dans ledit mot de code, uniquement de la valeur du bit pour lequel ledit nombre de changements de signe ou de différences de signe est le plus élevé, pour produire au moins un mot de code modifié,
- une étape supplémentaire de décodage (103) dudit au moins un mot de code modifié au moyen dudit algorithme itératif de décodage.

2. Procédé de décodage itératif d'un mot d'un code correcteur selon la revendication 1 dans lequel l'étape de modification (102) de la valeur d'un bit du mot de code et de décodage (103) du mot de code modifié sont itérées en modifiant, à chaque itération, la valeur du bit dudit mot de code pour lequel ledit nombre de changements de signe ou de différences de signe est le plus élevé parmi les bits dont la valeur n'a pas été modifiée à une itération précédente.

3. Procédé de décodage itératif d'un mot d'un code correcteur selon la revendication 1 dans lequel :
- simultanément à l'étape supplémentaire de décodage (103), pour chaque bit dudit mot de code, une nouvelle étape de détermination du nombre de changements de signes d'au moins une information extrinsèque (L_{i->j}, L_{1->2}, L_{2->1}) ou du nombre de différences de signes entre une information extrinsèque (L_{1->2}) et une autre information extrinsèque (L_{2->1}), au cours des itérations successives de décodage, est effectuée,
- l'étape de modification (102) de la valeur d'un bit du mot de code et de décodage (103) du mot de code modifié sont itérées en :
i. conservant la ou les modifications de valeurs de bit opérées aux itérations précédentes et,
ii. modifiant la valeur du bit dudit mot de code pour lequel ledit nombre de changements de signe ou de différences de signe est le plus élevé lors de l'étape supplémentaire de décodage effectuée à l'itération précédente.

4. Procédé de décodage itératif d'un mot d'un code correcteur selon l'une des revendications 2 ou 3 dans lequel les itérations des étapes de modification (102) de la valeur d'un bit du mot de code et de décodage (103) du mot de code modifié sont arrêtées à l'issu d'un nombre donné d'itérations.

5. Procédé de décodage itératif d'un mot d'un code correcteur selon l'une des revendications 2 ou 3 dans lequel les itérations des étapes de modification (102) de la valeur d'un bit du mot de code et de décodage (103) du mot de code modifié sont arrêtées dès que le décodeur converge.

6. Procédé de décodage itératif d'un mot d'un code correcteur selon l'une des revendications 2 ou 3 dans lequel lorsque le décodeur converge, le mot décodé est sauvegardé dans une liste, les itérations des étapes de modification de la valeur d'un bit du mot de code et de décodage du mot de code modifié étant arrêtées dès que la liste atteint (106) un nombre prédéterminé d'éléments.

7. Procédé de décodage itératif d'un mot d'un code correcteur selon la revendication 6 comprenant en outre une étape (105) de calcul, pour chaque élément de la liste des mots décodés, d'un critère de vraisemblance et de sélection du mot décodé qui optimise ledit critère de vraisemblance.

8. Procédé de décodage itératif d'un mot d'un code correcteur selon l'une des revendications précédentes dans lequel ledit algorithme de décodage itératif comporte l'utilisation d'un graphe bipartite, dit graphe de Tanner, comprenant une pluralité de premiers noeuds (Vⱼ), appelés noeuds variables, chaque noeud variable étant associé à un bit dudit mot de code, ledit graphe comprenant en outre une pluralité de seconds noeuds (Cᵢ), appelés noeuds de contrôle, chaque noeud variable (Vⱼ) étant connecté à au moins un noeud de contrôle (Cᵢ) pour recevoir une information extrinsèque (L_{i->j}) dudit noeud de contrôle, ledit procédé comprenant une étape de détermination du nombre de changements de signe, au cours des itérations successives de décodage, d'une information extrinsèque (L_{i->j}) reçue par un noeud variable (Vⱼ) en provenance d'un noeud de contrôle.

9. Procédé de décodage itératif d'un mot d'un code correcteur selon la revendication 8 dans lequel le comptage du nombre de changements de signe d'une information extrinsèque est effectué sur l'ensemble des informations extrinsèques reçues par un noeud variable en provenance d'un noeud de contrôle.

10. Procédé de décodage itératif d'un mot d'un code correcteur selon la revendication 8 dans lequel une information extrinsèque globale est calculée à partir de l'ensemble des informations extrinsèques reçues par un noeud variable en provenance d'un noeud de contrôle et le comptage du nombre de changements de signe d'une information extrinsèque est effectué sur l'information extrinsèque globale.

11. Procédé de décodage itératif selon l'une des revendications 8,9 ou 10 dans lequel ledit code correcteur est un code LDPC.

12. Procédé de décodage itératif d'un mot d'un code correcteur selon l'une des revendications 1 à 7 dans lequel ledit code correcteur est un turbo-code, ledit algorithme de décodage itératif comporte l'utilisation d'un premier décodeur (401) et d'un second décodeur (402) aptes à s'échanger une première information extrinsèque (L_{1->2}) et une seconde information extrinsèque (L_{2->1}), ledit procédé comprenant une étape de d étermination du nombre de changements de signe, au cours des itérations successives dudit algorithme de décodage itératif, de l'information extrinsèque reçue (L_{2->1}) par le second décodeur ou du nombre de changements de signe, au cours des itérations successives dudit algorithme de décodage itératif, de l'information extrinsèque reçue (L_{2->1}) par le second décodeur (402) et de l' information extrinsèque (L_{1->2}) reçue par le premier décodeur (401) ou du nombre de différences de signe, au cours des itérations successives dudit algorithme de décodage itératif, entre l'information extrinsèque reçue (L_{2->1}) par le second décodeur (402) et l'information extrinsèque (L_{1->2}) reçue par le premier décodeur (401) au cours d'une itération ou demi-itération.

13. Procédé de décodage itératif d'un mot d'un code correcteur selon l'une des revendications précédentes dans lequel ledit mot de code contient des valeurs binaires et la dite étape de modification de la valeur d'un bit dudit mot de code consiste à inverser la valeur dudit bit.

14. Procédé de décodage itératif d'un mot d'un code correcteur selon l'une des revendications 1 à 12 dans lequel ledit mot de code contient des valeurs souples et la dite étape de modification de la valeur d'un bit dudit mot de code consiste à saturer la valeur dudit bit respectivement à une valeur de saturation maximum positive et à une valeur de saturation minimum négative de sorte à produire deux mots de codes modifiés.

15. Procédé de décodage itératif d'un mot d'un code correcteur selon la revendication 14 en combinaison avec la revendication 3 dans lequel les itérations des étapes de modification de la valeur d'un bit du mot de code et de décodage du mot de code modifié sont représentées sous forme d'une arborescence dont les noeuds correspondent chacun à une itération de décodage associée à l'une des deux valeurs de saturation parmi la valeur maximum positive et la valeur minimum négative, ladite arborescence étant parcourue soit en largeur soit en profondeur.

16. Procédé de décodage itératif d'un mot d'un code correcteur selon la revendication 15 dans lequel, lorsque l'itération de décodage associée à un noeud de ladite arborescence a convergé, les noeuds fils dudit noeud ne sont pas parcourus.

17. Système récepteur de communications comprenant des moyens adaptés pour exécuter les étapes du procédé de décodage itératif selon l'une des revendications 1 à 16.

18. Programme d'ordinateur comportant des instructions pour l'exécution du procédé de décodage itératif selon l'une quelconque des revendications 1 à 16, lorsque le programme est exécuté par un processeur.

19. Support d'enregistrement lisible par un processeur sur lequel est enregistré un programme comportant des instructions pour l'exécution du procédé de décodage itératif selon l'une quelconque des revendications 1 à 16, lorsque le programme est exécuté par un processeur.

## Patentansprüche

1. Verfahren zur iterativen Decodierung eines Wortes eines Korrekturcodes mittels eines iterativen Decodierungsalgorithmus, bei dem für jedes Bit des Codeworts wenigstens eine extrinsische Information (L_{i->j}, L_{1->2}, L_{2->1}) bei jeder Iteration erzeugt wird, wobei das Verfahren die folgenden Schritte beinhaltet:
- einen ersten Schritt (101) des Decodierens des Codewortes mittels des iterativen Decodierungsalgorithmus,
- einen Schritt, gleichzeitig mit der iterativen Decodierung, für jedes Bit des Codeworts, des Bestimmens der Anzahl von Vorzeichenwechseln aus mindestens einer extrinsischen Information (L_{i->j}, L_{1->2}, L_{2->1}) oder der Anzahl von Vorzeichendifferenzen zwischen einer extrinsischen Information (L_{1->2}) und einer anderen extrinsischen Information (L_{2->1}) bei allen sukzessiven Iterationen des iterativen Decodierungsalgorithmus,
wenn die Decodierung nicht konvergiert, dann beinhaltet das Verfahren auch:
- einen Schritt (102) des Änderns, in dem Codewort, nur des Wertes des Bits, für das die Anzahl von Vorzeichenwechseln oder Vorzeichendifferenzen am höchsten ist, um wenigstens ein geändertes Codewort zu erzeugen,
- einen zusätzlichen Schritt (103) des Decodierens des wenigstens einen mittels des iterativen Decodierungsalgorithmus geänderten Codeworts.

2. Verfahren zur iterativen Decodierung eines Wortes eines Korrekturcodes nach Anspruch 1, bei dem der Schritt des Änderns (102) des Wertes eines Bits des Codeworts und des Decodierens (103) des geänderten Codeworts durch Ändern, bei jeder Iteration, des Wertes des Bits des Codeworts wiederholt werden, für das die Anzahl von Vorzeichenwechseln oder Vorzeichendifferenzen die höchste unter den Bits ist, deren Wert bei einer vorherigen Iteration nicht geändert wurde.

3. Verfahren zur iterativen Decodierung eines Wortes eines Korrekturcodes nach Anspruch 1, in dem:
- gleichzeitig mit dem zusätzlichen Decodierungsschritt (103), für jedes Bit des Codeworts, ein neuer Schritt des Bestimmens der Anzahl der Vorzeichenwechsel von wenigstens einer extrinsischen Information (L_{i->j}, L_{1->2}, L_{2->1}) oder der Anzahl von Vorzeichendifferenzen zwischen einer extrinsischen Information (L_{1->2}) und einer anderen extrinsischen Information (L_{2->1}) bei sukzessiven Decodierungsiterationen durchgeführt wird,
- der Schritt des Änderns (102) des Wertes eines Bits des Codeworts und des Decodierens (103) des geänderten Codeworts wiederholt werden unter:
i. Beibehaltung der ein oder mehreren Änderungen von Bitwerten, die bei früheren Iterationen angewendet wurden, und
ii. Änderung des Wertes des Bits des Codeworts, für das die Anzahl von Vorzeichenwechseln oder Vorzeichendifferenzen in dem bei der vorherigen Iteration durchgeführten zusätzlichen Decodierungsschritt am höchsten ist.

4. Verfahren zur iterativen Decodierung eines Wortes eines Korrekturcodes nach Anspruch 2 oder 3, bei dem die Iterationen der Schritte des Änderns (102) des Wertes eines Bits des Codeworts und des Decodierens (103) des geänderten Codeworts nach einer gegebenen Anzahl von Iterationen gestoppt werden.

5. Verfahren zur iterativen Decodierung eines Wortes eines Korrekturcodes nach Anspruch 2 oder 3, bei dem die Iterationen der Schritte des Änderns (102) des Wertes eines Bits des Codewortes und des Decodierens (103) des geänderten Codeworts gestoppt werden, sobald der Decoder konvergiert.

6. Verfahren zur iterativen Decodierung eines Wortes eines Korrekturcodes nach Anspruch 2 oder 3, bei dem, wenn der Decoder konvergiert, das decodierte Wort in einer Liste gespeichert wird, wobei die Iterationen der Schritte des Änderns des Wertes eines Bits des Codeworts und des Decodierens des geänderten Codeworts gestoppt werden, sobald die Liste eine vorbestimmte Anzahl von Elementen erreicht (106).

7. Verfahren zur iterativen Decodierung eines Wortes eines Korrekturcodes nach Anspruch 6, das ferner einen Schritt des Berechnens (105), für jedes Element der Liste der decodierten Wörter, eines Plausibilitäts- und Auswahlkriteriums des decodierten Wortes beinhaltet, das das Plausibilitätskriterium optimiert.

8. Verfahren zur iterativen Decodierung eines Wortes eines Korrekturcodes nach einem der vorherigen Ansprüche, bei dem der iterative Decodierungsalgorithmus die Verwendung eines zweiteiligen Graphen, Tanner-Graphen genannt, beinhaltet, der mehrere Knoten (Vⱼ), variable Knoten genannt, beinhaltet, wobei jeder variable Knoten mit einem Bit des Codeworts assoziiert ist, wobei der Graph ferner mehrere zweite Knoten (Cᵢ), Kontrollknoten genannt, umfasst, wobei jeder variable Knoten (Vⱼ) mit wenigstens einem Kontrollknoten (Cᵢ) verbunden ist, um eine extrinsische Information (L_{i->j}) des Kontrollknotens zu empfangen, wobei das Verfahren einen Schritt des Bestimmens der Anzahl von Vorzeichenwechseln, bei sukzessiven Decodierungsiterationen, einer extrinsischen Information (L_{i->j}) umfasst, die von einem von einem Kontrollknoten kommenden variablen Knoten (Vᵢ) empfangen werden.

9. Verfahren zur iterativen Decodierung eines Wortes eines Korrekturcodes nach Anspruch 8, bei dem das Zählen der Anzahl der Vorzeichenwechsel einer extrinsischen Information an allen extrinsischen Informationen gezählt wird, die von einem von einem Kontrollknoten kommenden variablen Knoten empfangen werden.

10. Verfahren zur iterativen Decodierung eines Wortes eines Korrekturcodes nach Anspruch 8, bei dem eine globale extrinsische Information auf der Basis aller extrinsischen Informationen berechnet wird, die von einem von einem Kontrollknoten kommenden variablen Knoten empfangen werden, und das Zählen der Anzahl der Vorzeichenwechsel einer extrinsischen Information an der globalen extrinsischen Information erfolgt.

11. Verfahren zur iterativen Decodierung nach Anspruch 8, 9 oder 10, wobei der Korrekturcode ein LDPC-Code ist.

12. Verfahren zur iterativen Decodierung eines Wortes eines Korrekturcodes nach einem der Ansprüche 1 bis 7, bei dem der Korrekturcode ein Turbocode ist, wobei der iterative Decodierungsalgorithmus die Verwendung eines ersten Decoders (401) und eines zweiten Decoders (402) beinhaltet, die eine erste extrinsische Information (L_{1->2}) und eine zweite extrinsische Information (L_{2->1}) austauschen können, wobei das Verfahren einen Schritt des Bestimmens der Anzahl von Vorzeichenwechseln, bei sukzessiven Iterationen des iterativen Decodierungsalgorithmus, der vom zweiten Decoder empfangenen extrinsischen Information (L_{2->1}) oder der Anzahl von Vorzeichenwechseln, bei sukzessiven Iterationen des iterativen Decodierungsalgorithmus, der vom zweiten Decoder (402) empfangenen extrinsischen Information (L_{2->1}) und der vom ersten Decoder (401) empfangenen extrinsischen Information (L_{1->2}) oder der Anzahl von Vorzeichendifferenzen, bei sukzessiven Iterationen des iterativen Decodierungsalgorithmus, zwischen der vom zweiten Decoder (402) empfangenen extrinsischen Information (L_{2->1}) und der vom ersten Decoder (401) empfangenen extrinsischen Information (L_{1->2}) bei einer Iteration oder Halb-Iteration beinhaltet.

13. Verfahren zur iterativen Decodierung eines Wortes eines Korrekturcodes nach einem der vorherigen Ansprüche, bei dem das Codewort Binärwerte enthält und der Schritt des Änderns des Wertes eines Bits des Codeworts darin besteht, den Wert des Bits umzukehren.

14. Verfahren zur iterativen Decodierung eines Wortes eines Korrekturcodes nach einem der Ansprüche 1 bis 12, bei dem das Codewort flexible Werte enthält und der Schritt des Änderns des Wertes eines Bits des Codeworts darin besteht, den Wert des Bits jeweils auf einen positiven maximalen Sättigungswert und einen negativen minimalen Sättigungswert zu sättigen, um zwei geänderte Codewörter zu erzeugen.

15. Verfahren zur iterativen Decodierung eines Wortes eines Korrekturcodes nach Anspruch 14 in Kombination mit Anspruch 3, bei dem die Iterationen der Schritte des Änderns des Wertes eines Bits des Codeworts und des Decodierens des geänderten Codeworts in Form einer Baumstruktur dargestellt werden, deren Knoten jeweils einer Decodier-Iteration entsprechen, die mit einem der beiden Sättigungswerte unter dem positiven maximalen Wert und dem negativen minimalen Wert assoziiert ist, wobei die Baumstruktur entweder der Breite nach oder der Tiefe nach durchlaufen wird.

16. Verfahren zur iterativen Decodierung eines Wortes eines Korrekturcodes nach Anspruch 15, bei dem, wenn die mit einem Knoten der Baumstruktur assoziierte Decodierungsiteration konvergiert ist, die Kindknoten nicht durchlaufen werden.

17. Kommunikationsempfangssystem, das Mittel umfasst, die zur Durchführung der Schritte des iterativen Decodierungsprozesses nach einem der Ansprüche 1 bis 16 ausgelegt sind.

18. Computerprogramm mit Befehlen zur Durchführung des Verfahrens zur iterativen Decodierung nach einem der Ansprüche 1 bis 16, wenn das Programm von einem Prozessor ausgeführt wird.

19. Aufzeichnungsmedium, das von einem Prozessor gelesen werden kann, auf dem ein Programm aufgezeichnet ist, das Befehle zum Ausführen des iterativen Decodierungsverfahrens nach einem der Ansprüche 1 a 16 umfasst, wenn das Programm von einem Prozessor ausgeführt wird.

## Claims

1. Method for iteratively decoding a word of a correcting code by means of an iterative decoding algorithm in the course of which, for each bit of said code word, at least one extrinsic information item (L_{i->j}, L_{1->2}, L_{2->1}) is generated at each iteration, said method including the following steps:
- an initial step of decoding (101) said code word by means of said iterative decoding algorithm;
- simultaneously with said iterative decoding, for each bit of said code word, a step of determining the number of sign changes of at least one extrinsic information item (L_{i->j}, L_{1->2}, L_{2->1}) or the number of sign differences between an extrinsic information item (L_{1->2}) and another extrinsic information item (L_{2->1}), in the course of all the successive iterations of said iterative decoding algorithm;
if the decoding does not converge, said method further comprising
- a step of modifying (102), in said code word, only the value of the bit for which said number of sign changes or sign differences is the highest, to produce at least one modified code word,
- an additional step of decoding (103) said at least one modified code word by means of said iterative decoding algorithm.

2. Method for iteratively decoding a word of a correcting code according to claim 1, in which the step of modifying (102) the value of one bit of the code word and of decoding (103) the modified code word are iterated while modifying, at each iteration, the value of the bit of said code word for which said number of sign changes or sign differences is the highest among the bits whose value has not been modified in a previous iteration.

3. Method for iteratively decoding a word of a correcting code according to claim 1, in which:
- simultaneously with the additional step of decoding (103), for each bit of said code word, a new step of determining the number of sign changes of at least one extrinsic information item (L_{i->j}, L_{1->2}, L_{2->1}) or the number of sign differences between an extrinsic information item (L_{1->2}) and another extrinsic information item (L_{2->1}), in the course of the successive decoding iterations, is carried out,
- the step of modifying (102) the value of one bit of the code word and of decoding (103) the modified code word are iterated while:
i. preserving the modification or modifications of bit values effected in the previous iterations, and
ii. modifying the value of the bit of said code word for which said number of sign changes or sign differences is the highest in the additional decoding step carried out in the previous iteration.

4. Method for iteratively decoding a word of a correcting code according to one of claims 2 or 3, in which the iterations of the steps of modifying (102) the value of one bit of the code word and of decoding (103) the modified code word are stopped at the end of a given number of iterations.

5. Method for iteratively decoding a word of a correcting code according to one of claims 2 or 3, in which the iterations of the steps of modifying (102) the value of one bit of the code word and of decoding (103) the modified code word are stopped as soon as the decoder converges.

6. Method for iteratively decoding a word of a correcting code according to one of claims 2 or 3, in which, when the decoder converges, the decoded word is saved in a list, the iterations of the steps of modifying the value of one bit of the code word and of decoding the modified code word being stopped as soon as the list reaches (106) a predetermined number of elements.

7. Method for iteratively decoding a word of a correcting code according to claim 6, furthermore comprising a step of computing (105), for each element in the list of the decoded words, a criterion of likelihood and selection of the decoded word that optimizes said likelihood criterion.

8. Method for iteratively decoding a word of a correcting code according to any one of the preceding claims, in which said iterative decoding algorithm includes the use of a bipartite graph, called a Tanner graph, comprising a plurality of first nodes (Vⱼ), called variable nodes, each variable node being associated with one bit of said code word, said graph furthermore comprising a plurality of second nodes (Cᵢ), called check nodes, each variable node (Vⱼ) being connected to at least one check node (Cᵢ) to receive an extrinsic information item (L_{i->j}) from said check node, said method comprising a step of determining the number of sign changes, in the course of the successive decoding iterations, of an extrinsic information item (L_{i->j}) received by a variable node (Vⱼ) originating from a check node.

9. Method for iteratively decoding a word of a correcting code according to claim 8, in which the counting of the number of sign changes of an extrinsic information item is carried out on all the extrinsic information items received by a variable node originating from a check node.

10. Method for iteratively decoding a word of a correcting code according to claim 8, in which a global extrinsic information item is computed on the basis of all the extrinsic information items received by a variable node originating from a check node and the counting of the number of sign changes of an extrinsic information item is carried out on the global extrinsic information item.

11. Method for iterative decoding according to claims 8, 9 or 10, in which said correcting code is an LDPC code.

12. Method for iteratively decoding a word of a correcting code according to one of claims 1 to 7, in which said correcting code is a turbo code, said iterative decoding algorithm includes the use of a first decoder (401) and of a second decoder (402) capable of exchanging with each other a first extrinsic information item (L_{1->2}) and a second extrinsic information item (L_{2->1}), said method comprising a step of determining the number of sign changes, in the course of the successive iterations of said iterative decoding algorithm, of the extrinsic information item (L_{2->1}) received by the second decoder or the number of sign changes, in the course of the successive iterations of said iterative decoding algorithm, of the extrinsic information item (L_{2->1}) received by the second decoder (402) and of the extrinsic information item (L_{1->2}) received by the first decoder (401) or the number of sign differences, in the course of the successive iterations of said iterative decoding algorithm, between the extrinsic information item (L_{2->1}) received by the second decoder (402) and the extrinsic information item (L_{1->2}) received by the first decoder (401) in the course of one iteration or one half-iteration.

13. Method for iteratively decoding a word of a correcting code according to any one of the preceding claims, in which said code word contains binary values and said step of modifying the value of one bit of said code word consists in inverting the value of said bit.

14. Method for iteratively decoding a word of a correcting code according to any one of claims 1 to 12, in which said code word contains soft values and said step of modifying the value of one bit of said code word consists in saturating the value of said bit to a positive maximum saturation value and to a negative minimum saturation value respectively, so as to produce two modified code words.

15. Method for iteratively decoding a word of a correcting code according to claim 14 in combination with claim 3, in which the iterations of the steps of modifying the value of one bit of the code word and of decoding the modified code word are represented in the form of a tree whose nodes each correspond to a decoding iteration associated with one of the two saturation values from among the positive maximum value and the negative minimum value, said tree being traversed either width-wise or depth-wise.

16. Method for iteratively decoding a word of a correcting code according to claim 15, in which, when the decoding iteration associated with a node of said tree has converged, the child nodes of said node are not traversed.

17. System for receiving communications comprising means adapted for executing the steps of the iterative decoding method according to one of claims 1 to 16.

18. Computer program including instructions for executing the iterative decoding method according to any one of claims 1 to 16, when the program is executed by a processor.

19. Storage medium readable by a processor, on which a program is stored including instructions for executing the iterative decoding method according to any one of claims 1 to 16, when the program is executed by a processor.
